# EUROPEAN PATENT APPLICATION

(11) **EP 4 832 297 A1**
(43) Date of publication of application: **28.10.2026**
(21) Application number: 25848952.5
(22) Date of filing: 30.07.2025
(51) Int. Cl.: H02J 7/00, G01R 31/382, G01R 31/374, G01R 31/367

(54) **ELECTRONIC DEVICE FOR PERFORMING BATTERY CELL BALANCING METHOD AND CONTROL METHOD THEREOF**

(30) Priority: 01.08.2024 KR 20240102615
(71) Applicant: LG Energy Solution, Ltd., Seoul 07335 (KR)
(72) Inventor: YANG, Myungcheol, Daejeon 34122 (KR); KIM, Cheoltaek, Daejeon 34122 (KR); LEE, Sun Jong, Daejeon 34122 (KR)
(74) Representative: BCKIP Part mbB
(86) International application number: PCT/KR2025/011375
(87) International publication number: WO 2026/029578

(57) **Abstract**

Disclosed are an electronic device for performing a battery cell balancing method and a control method thereof, the electronic device comprising: an information acquisition interface for acquiring voltages of a plurality of battery cells inside a plurality of battery modules included in a battery rack; a memory for storing instructions; and a processor connected to the memory, wherein the processor is configured to measure the voltages of the plurality of battery cells inside the plurality of battery modules included in the battery rack in an idle state, measure SoCs of the plurality of battery cells in the idle state on the basis of the voltages, measure the SoCs of the plurality of battery modules in the idle state on the basis of the SoCs of the plurality of battery cells in the idle state, determine first battery modules to be subjected to first balancing from among the plurality of battery modules, and perform first balancing between the first battery modules.

## Description

### Technical Field

The present disclosure relates to an electronic device performing a method for balancing battery cells and a control method therefor.

### Background Art

A battery balancing technique refers to the technique of maintaining and managing the deviation of the states of charge (SOC) of battery cells in a battery rack so that the deviation is minimized, in order to operate batteries safely, efficiently, and for a long time.

Particularly, through battery cell balancing in an identical battery rack, the overcharging/over-discharging of the battery cells may be prevented, the danger of thermal runaway may be reduced, the energy efficiency may be maximized, and the stable voltage output may be guaranteed.

A mainly used battery cell balancing technique has focused on the process of measuring the voltage of a battery cell in the battery rack, extracting the SoC in the paused state, selecting cells having a large deviation compared to a cell having the minimum SoC, and matching the SoC deviation of all the cells to a predetermined level, and a large number of studies of a further developed cell balancing technique are currently conducted recently.

### Detailed Description of the Invention

### Technical Goals

Example embodiments of the present disclosure are to increase accuracy of a battery diagnosis by identifying a consumed capacity due to balancing by SoC section of a plurality of batteries and determining a compensating voltage in consideration of a consumed capacity at a time of detecting a micro-short circuit in a battery.

However, the goals to be achieved by example embodiments of the present disclosure are not limited to the objectives described above and other objects may be clearly understood from the following example embodiments.

### Technical solutions

According to an aspect, there is provided an electronic device configured to perform a method of balancing battery cells, the electronic device including an information acquisition interface configured to acquire voltages of a plurality of battery cells in a plurality of battery modules included in a battery rack, a memory configured to store an instruction, and a processor connected to the memory, and the processor is configured to measure the voltages of the plurality of battery cells in the plurality of battery modules included in the battery rack in a paused state, measure states of charge (SoC) of the plurality of battery cells in the paused state based on the voltages and measure SoC of the plurality of battery modules in the paused state based on the SoC of the plurality of battery cells in the paused state, determine first battery modules that are objects of first balancing among the plurality of battery modules, and perform the first balancing of the first battery modules.

The processor may be configured to determine battery modules, which have SoC higher than an SoC of a reference battery module that is a reference for the first balancing within a predefined first deviation, to be the first battery modules.

The processor may be configured to determine a reference battery module that is a reference for the first balancing among the plurality of battery modules, and perform the first balancing at a first frequency until a difference between the SoC of the first battery modules and an SoC of the reference battery module is within a predefined second deviation.

The processor may be configured to determine reference battery cells that are a reference for second balancing among battery cells included in each of the plurality of battery modules, determine battery cells, which have SoC higher than an SoC of a reference battery cell that is the reference for the second balancing within a predefined third deviation, to be first battery cells, and perform the second balancing at a second frequency until a difference between the SoC of the first battery cells and SoC of the reference battery cells is within a predefined fourth deviation.

The first frequency may have a value larger than that of the second frequency for performing second balancing of the plurality of battery cells which is included in each of the plurality of battery modules.

The first deviation in the first balancing may be different from a third deviation in second balancing.

The processor may be configured to measure the SoC of the plurality of battery modules in the paused state based on an average of the SoC of the plurality of battery cells in the paused state which is included in each of the plurality of battery modules in the paused state.

The processor may be configured to determine reference battery cells, which have lowest SoC among the battery cells included in each of the plurality of battery module, to be the reference battery cell.

According to another aspect, there is also provided a method of balancing battery cells, the method performed by an electronic device and including measuring voltages of a plurality of battery cells in a plurality of battery modules included in a battery rack in a paused state, measuring states of charge (SoC) of the plurality of battery cells in the paused state based on the voltages and measuring SoC of the plurality of battery modules in the paused state based on the SoC of the plurality of battery cells in the paused state, determining first battery modules that are objects of first balancing among the plurality of battery modules, and performing the first balancing of the first battery modules.

Additional aspects of example embodiments will be set forth in part in the description which follows and, in part, will be apparent from the description, or may be learned by practice of the disclosure.

### Effects of the Invention

According to example embodiments, one or more of the following effects may be expected.

According to example embodiments of the present disclosure, since SoC of battery modules existing in a battery rack may be uniformly maintained, even when a predetermined battery module is replaced due to a defect, collective management with a battery module existing earlier in the battery rack is allowed.

According to example embodiments of the present disclosure, since balancing of battery cells in a battery module may be performed after balancing of the battery modules is performed, it is possible to uniformly manage battery cells in an identical battery module.

Effects of the present disclosure are not limited to those described above and other effects may be made apparent to those skilled in the art from the following description of the accompanying claims.

### Brief Description of Drawings

FIG. 1 illustrates an interlocking relationship of an electronic device that performs a method of balancing battery cells according to an example embodiment.
FIG. 2 is a diagram for describing a relationship between a battery rack, a battery module, and a battery cell according to an example embodiment.
FIG. 3 is a block diagram illustrating a configuration of an electronic device according to an example embodiment.
FIGS. 4A and 4B are diagrams for describing a concept of balancing battery cells according to an example embodiment.
FIG. 5 is a flowchart for describing a method for balancing battery cells according to an example embodiment.

### Mode for Carrying Out the Invention

Terms used in the example embodiments are selected, as much as possible, from general terms that are widely used at present while taking into consideration the functions obtained in accordance with the present disclosure, but these terms may be replaced by other terms based on intentions of those skilled in the art, customs, emergence of new technologies, or the like. Also, in a particular case, terms that are arbitrarily selected by the applicant of the present disclosure may be used. In this case, the meanings of these terms may be described in corresponding description parts of the disclosure. Accordingly, it should be noted that the terms used herein should be construed based on practical meanings thereof and the whole content of this specification, rather than being simply construed based on names of the terms.

In the entire specification, when an element is referred to as "including" another element, the element should not be understood as excluding other elements so long as there is no special conflicting description, and the element may include at least one other element.

Throughout the specification, expression "at least one of a, b, and c" may include 'a only', 'b only', 'c only', 'a and b', 'a and c', 'b and c', or 'all of a, b, and c'.

In the present disclosure, a "terminal" may be implemented as a computer or a portable terminal capable of accessing a server or another apparatus through a network. The computer may include, for example, a laptop computer, a desktop computer, and a notebook equipped with a web browser. The portable apparatus may be a wireless communication device ensuring a portability and a mobility, and include any type of handheld wireless communication device, for example, a tablet PC, a smartphone, a communication-based apparatus such as international mobile telecommunication (IMT), code division multiple access (CDMA), W-code division multiple access (W-CDMA), and long term evolution (LTE).

In the following description, example embodiments of the present disclosure will be described in detail with reference to the accompanying drawings so that those skilled in the art can easily carry out the present disclosure. However, the present disclosure may be embodied in many different forms and is not limited to the example embodiments described herein.

Hereinafter, the example embodiments of the present disclosure will be described with reference to the accompanying drawings.

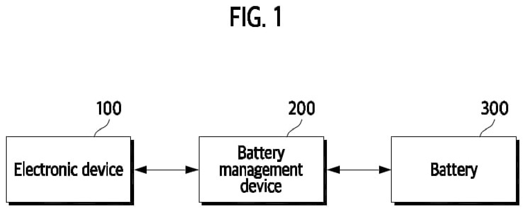

FIG. 1 illustrates an interlocking relationship of an electronic device that performs a method of balancing battery cells according to an example embodiment.

Referring to FIG. 1, an electronic device 100 may be interlocked with a battery management device 200 managing a battery 300 to operate. At this point, the battery 300 may include a battery module, into which a plurality of battery cells corresponding to a smallest battery unit that stores and discharges electrical energy through a chemical reaction is assembled and which provides a voltage and a capacity higher than those of a single cell, and a battery rack that forms a complete battery system as a plurality of battery modules is assembled thereto. Meanwhile, particular elements, which are associated with the present example embodiment, are illustrated in FIG. 1. Thus, those skilled in the art associated with the present example embodiment may understand that other elements in general use in addition to the elements illustrated in FIG. 1 may be further included.

The electronic device 100 is a device that configures and provides a variety of information. The electronic device 100 may acquire information associated with a battery cell included in the battery 300. The electronic device 100 may provide a function of balancing the battery modules and a function of balancing the battery cells in the battery module. Battery balancing may include first balancing of equalizing charge and discharge capacities of the battery modules and second balancing of equalizing charge and discharge capacities of the battery cells in the battery module for guaranteeing an optimal life, performance, and safety. The electronic device 100 may provide a passive balancing function for preventing overcharging and over-discharging of the battery cell due to a change in a capacity and a voltage of the battery cell occurring due to a manufacturing property difference, deterioration, or an operating condition of the battery cell which forms the battery module included in the battery rack. The passive balancing may correspond to a process of emitting excessive energy in heat by connecting a resistor to each battery cell. In an example embodiment, the electronic device 100 may correspond to a server, an analysis device, or a charging device that receives a parameter associated with the battery 300 from the battery management device 200 which is in a vehicle and that directs the battery management device 200 to perform the method of balancing the battery cells according to the present disclosure. The electronic device 100 may measure voltages of the plurality of battery cells in the plurality of battery modules included in the battery 300 in a paused state by receiving the parameter associated with the battery 300 from the battery management device 200. The electronic device 100 may be configured to measure states of charge (SoC) of the plurality of battery cells in the paused state based on the voltages, determine first battery modules that are objects of the first balancing among the plurality of battery modules, and then perform the first balancing of the first battery modules through the battery management device 200. The electronic device 100 may be configured to additionally perform the second balancing on the plurality of battery cells in the plurality of battery modules through the battery management device 200. Overall processes of performing the first balancing and the second balancing will be described below in detail.

The battery management device 200 may include one or more sensors for measuring a parameter such as an electric current, a voltage, an initial SoC, an internal resistance, and an internal temperature of the battery cell 300 and include a memory and a processor (not illustrated) for various operations. In other words, the above-described batter management device 200 may operate based on the memory and the processor similarly to the electronic device 100, but may additionally include a sensor to measure and calculate the parameter of the battery cell 300. In addition, the battery management device 200 may perform overall operation and simulation, which are performed by the electronic device 100 as described simply above, in a similar way.

Here, the electronic device 100 and the battery management device 200 each may be a completely separated and independent object. However, the electronic device 100 and the battery management device 200 may be only conceptually separated to exist in one device or system. That is, in some example embodiments, the electronic device 100 may be coupled to the battery management device 200 to exist in one vehicle system and may control the balancing of the battery modules in the battery rack included in the battery 300 in a vehicle and control the balancing of the battery cells included in the battery module. That is, one computing device having a control function for the battery may perform all functions of the electronic device 100 and the battery management device 200 which will be described below, and accordingly, such an example embodiment is regarded as being included in the scope of the present disclosure.

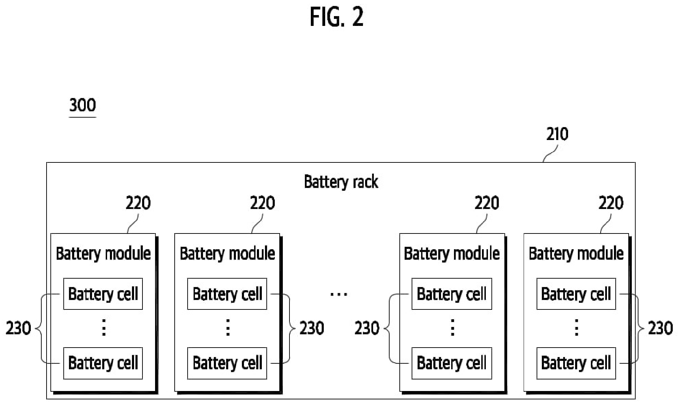

FIG. 2 is a diagram for describing a relationship between a battery rack, a battery module, and a battery cell according to an example embodiment.

Referring to FIG. 2, a connection relationship between a battery rack 210, a plurality of battery modules 220, and a plurality of battery cells 230 included in a battery according to an example embodiment may be identified. The battery rack 210 according to an example embodiment may include the plurality of battery modules 220. In an example embodiment, the plurality of battery modules 220 included in the battery rack 210 may be connected in series, and the plurality of battery cells 230 which is included in the plurality of battery modules 220 may be connected in series. In other words, the battery described above with reference to FIG. 1 may be formed hierarchically from a battery cell that is a basic unit storing and discharging electrical energy. The plurality of battery cells 230 may be grouped together to form the plurality of battery modules 220 which provides a voltage and a capacity higher than those for discharging and storing independently by a single battery cell. The plurality of battery modules 220 may be assembled to the battery rack 210, and the battery rack 210 may provide appropriate electrical connection and structure support by serving as a framework that receives and forms the plurality of battery modules 220. The following description of the battery modules 220 may be identically applied to a battery pack formed as a plurality of battery cells are connected.

The electronic device 100 and the battery management device 200 described with reference to FIG. 1 may communicate with each of the plurality of battery cells 230, monitor voltages, electric currents, and temperatures of the plurality of battery cells 230, calculate statuses of charge (SoC) of the plurality of battery cells 230, and control charging and discharging. The electronic device 100 and the battery management device 200 may perform a first balancing function corresponding to a passive balancing scheme that consumes energy of another battery module based on a battery module having a lowest SoC among the plurality of battery modules 220 included in the battery rack 210. The electronic device 100 and the battery management device 200 may perform a first balancing function corresponding to a passive balancing scheme that consumes energy of other battery cells in an identical battery module based on a battery cell having a lowest SoC among the plurality of battery cells 230 included in each of the plurality of battery modules 220.

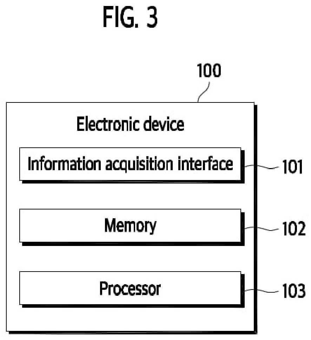

FIG. 3 is a block diagram illustrating a configuration of an electronic device according to an example embodiment.

Referring to FIG. 3, the electronic device 100 according to an example embodiment may include a processor 101 and a processor 102. Particular elements, which are associated with the present example embodiment, are illustrated with respect to the electronic device 100 which is illustrated in FIG. 3. Thus, those skilled in the art associated with the present example embodiment may understand that other elements in general use in addition to the elements illustrated in FIG. 3 may be further included.

An information acquisition interface 101 according to an example embodiment may acquire time-series data on a voltage of each of a plurality of battery cells and a plurality of battery modules included in a battery. For example, the information acquisition interface 101 may acquire a voltage value of each battery module or each battery cell at intervals of a predetermined time and acquire time-series data on the voltage value. In other words, the time-series data may be a set of voltage values acquired at a plurality of time points. The information acquisition interface 101 may further acquire data such as an electric current, a temperature, or an SoC (State-Of-Charge) in addition to a voltage of a battery module or a battery cell. When the electronic device 100 which performs a method of diagnosing the battery cell is a battery management device (BMS) of the battery, the information acquisition interface 101 may be an element that directly measures a battery voltage, for example, a voltage sensor or the like. In addition, when the electronic device 100 corresponds to a vehicle on-board diagnostics (OBD) device, a server, a cloud BMS, or a charger/discharger, the information acquisition interface 101 may be a communication interface that receives voltage information measured from an element that measures a voltage of a battery pack (e.g., the voltage sensor of the battery). The processor 103 may diagnose a status of each battery cell by analyzing the time-series data which is acquired from the information acquisition interface 101. Unless noted otherwise, the processor 103 in the present disclosure may refer to a set of one or more processors.

The memory 102 according to an example embodiment may be hardware that stores a variety of data processed in the electronic device 100. The memory 102 may be positioned in the processor 103 in the electronic device 100 and may store data processed and to be processed through the processor 103. Also, the memory may store a basic programming and data structure for providing a function of at least one example embodiment of the present disclosure and also store applications (e.g., a program, a code module, or an instruction), drivers, and the like that may provide the function of the at least one example embodiment of the present disclosure. The memory may include a random access memory (RAM) such as a dynamic random access memory (DRAM) and a static random access memory (SRAM), a read-only memory (ROM), an electrically erasable programmable read-only memory (EEPROM), a compact disc (CD)-ROM, Blu-ray or another optical disc storage, a hard disk drive (HDD), a solid state drive (SSD), or a flash memory, but is not limited to a predetermined case described by example embodiments of the present disclosure.

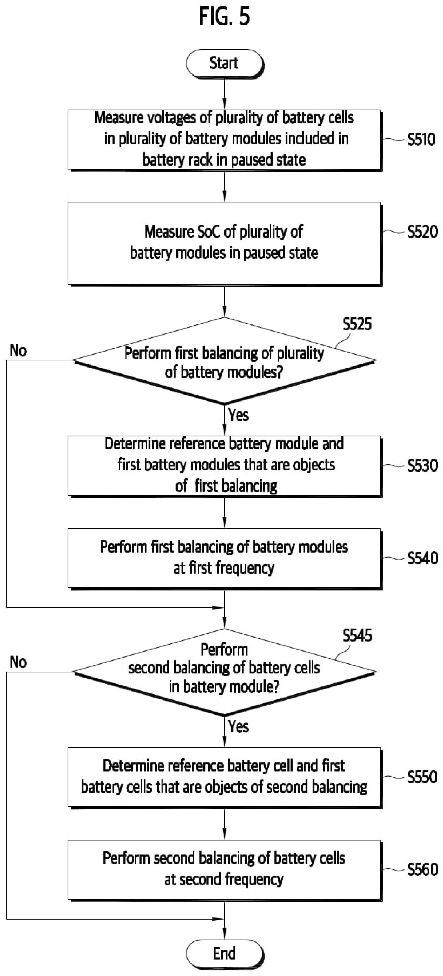

In an example embodiment, the processor 103 may control overall operations of the electronic device 100 and may process data and a signal. The processor 103 may be formed with at least one hardware unit. In addition, the processor 103 may be operated by one or more software modules generated by executing program code stored in the memory 101. Since the processor 103 may include the memory 101, the processor 103 may control the overall operations of the electronic device 100 and process the data and the signal by executing program code stored in the memory 101. That is, the processor 103 according to an example embodiment may be configure to measure voltages of the plurality of battery cells in the plurality of battery modules included in a battery rack in a paused state, measure SoC of the plurality of battery cells in the paused state based on the voltages, measure SoC of the plurality of battery modules in the paused state based on the SoC of the plurality of battery cells in the paused state, determine first battery modules that are objects of first balancing among the plurality of battery modules, and perform the first balancing of the first battery modules. Also, the electronic device 100 may be configured to additionally perform second balancing on the plurality of cells in the plurality of battery modules. This will be described in detail below with reference to FIG. 5.

The electronic device 100 according to the above-described example embodiments may include a processor, a memory that stores and executes program data, a permanent storage such as a disk drive, a communication port for communicating with an external device, and a user interface device such as a touch panel, a key, and a button. Methods implemented by software modules or algorithms may be stored in a computer-readable recording medium as computer-readable code or program instructions executable in the processor. Here, the computer-readable recording medium may include a magnetic storage medium (e.g., a read-only memory (ROM), a random-access memory (RAM), a floppy disk, a hard disk, or the like), an optical reading medium (e.g., a CD-ROM or a digital versatile disc (DVD)), or the like. The computer-readable recording medium may be dispersed to computer systems connected by a network so that computer-readable codes may be stored and executed in a dispersed manner. The medium may be read by a computer, stored in the memory, and executed by the processor.

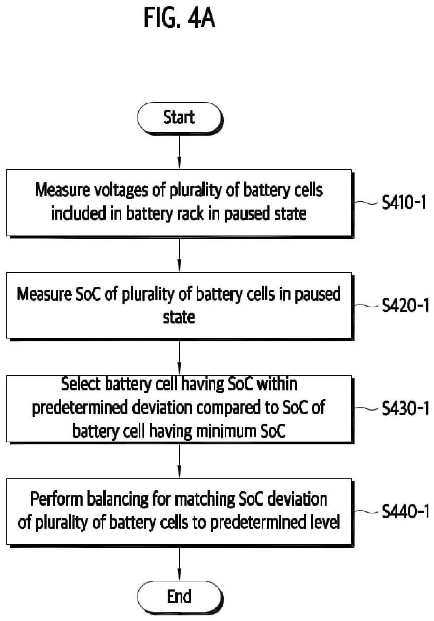

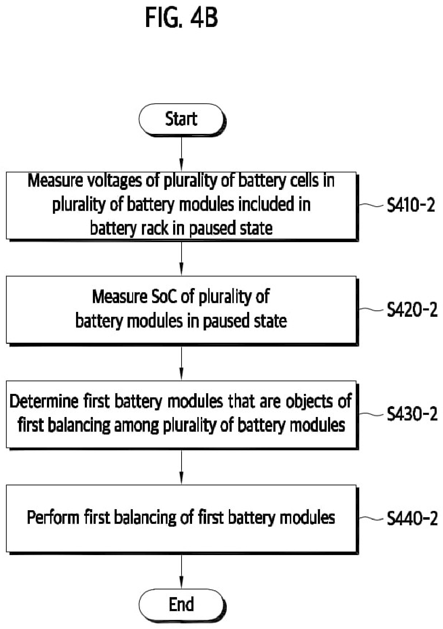

FIGS. 4A and 4B are diagrams for describing a concept of balancing battery cells according to an example embodiment.

Referring to FIG. 4A, in operation S410-1, the electronic device 100 according to an example embodiment may measure voltages of a plurality of battery cells included in a battery rack in a paused state. The electronic device 100 according to an example embodiment may measure a voltage of a battery cell in the paused state after a predetermined time so as to reach an equilibrium in which the voltage is stabilized after charging or discharging of the battery cell is finished. The voltage of the battery cell in the paused state may correspond to an open circuit voltage (OCV) of the battery cell.

In operation S420-1, the electronic device 100 according to an example embodiment may measure an SoC of the battery cell in the paused state. The electronic device 100 according to an example embodiment may measure the SoC of the battery cell in the paused state based on a relationship between the SoC and the open circuit voltage of the battery cell in the paused state.

In operation S430-1, the electronic device 100 according to an example embodiment may select a battery cell having an SoC within a predetermined deviation compared to an SoC of a battery cell having a minimum SoC. The electronic device 100 may identify the battery cell having the minimum SoC among all battery cells included in the battery rack and select a battery cell having an SoC higher within the predetermined deviation. For example, when the SoC of the battery cell having the minimum SoC among all the battery cells included in the battery rack is 70 volts (V), the electronic device 100 may select a battery cell having an SoC higher within a predetermined deviation of 5% and having an SoC greater than or equal to 70% and less than or equal to 73.5%. Since a difference in SoC of battery cells in an identical battery rack may also occur within a predetermined deviation due to a difference in materiality in manufacturing and degradation levels, a battery cell having an SoC higher within the predetermined deviation may be determined to be a battery cell that is an object of balancing.

In operation S440-1, the electronic device 100 according to an example embodiment may perform the balancing for matching an SoC deviation of the plurality of battery cells to a predetermined level. In this case, the balancing may be passive balancing, and the balancing of identifying the above-described battery cell having the minimum SoC among all the battery cells included in the battery rack, connecting a resistance component to each battery cell having the SoC higher within the predetermined deviation, allowing the SoC to be consumed, and matching the SoC deviation of the plurality of battery cells included in the battery rack to the predetermined level may be performed.

Referring to FIG. 4B, in operation S410-2, the electronic device 100 according to an example embodiment may measure voltages of a plurality of battery cells in a plurality of battery modules included in the battery rack in the paused state. The electronic device 100 may measure open circuit voltages in the paused state of the plurality of battery cells included in each of the plurality of battery modules in the paused state.

In operation S420-2, the electronic device 100 according to an example embodiment may measure SoC of the plurality of battery cells in the paused state and measure SoC of the plurality of battery modules in the paused state based on the SoC of the plurality of battery cells in the paused state. For example, the electronic device 100 may measure an SoC of each of the plurality of battery modules in the paused state based on an average of the SoC of the plurality of battery cells in the paused state included in each of the plurality of battery modules in the paused state.

In operation S430-2, the electronic device 100 according to an example embodiment may determine first battery modules that are objects of first balancing among the plurality of battery modules. The electronic device 100 may determine a battery module, which has a minimum SoC among the plurality of battery modules, to be a reference battery module and determine battery modules, which have SoC higher than an SoC of the reference module within a predefined first deviation, to be the first battery modules.

The predefined first deviation may be defined as a % value that is based on the SoC of the reference battery module. In other words, when the SoC of the reference battery module is a%, and when the predefined first deviation is b%, an SoC of the first battery module, which is higher than the SoC of the reference battery module within the predefined first deviation, may be defined as such in the following Equation 1. [Equation 1] $a < SoC of first battery module \leq a X \left(1+\frac{b}{100}\right) \left(%\right)$

In other words, the electronic device 100 according to an example embodiment may determine a battery module, which has an SoC exceeding the SoC of the reference battery module and within the first deviation from the SoC of the reference battery module, to be a first battery module.

In operation S440-2, the electronic device 100 according to an example embodiment may perform the first balancing of the first battery modules. In this case, the first balancing may include overall processes of reducing an SoC of the first battery module through passive balancing of an entire plurality of battery cells included in the first battery module.

FIG. 5 is a flowchart for describing a method for balancing battery cells according to an example embodiment.

Referring to FIG. 5, in operation S510, the electronic device 100 according to an example embodiment may measure voltages of a plurality of battery cells in a plurality of battery modules included in a battery rack in a paused state.

In operation S520, the electronic device 100 according to an example embodiment may measure SoC of the plurality of battery cells in the paused state and measure SoC of the plurality of battery modules in the paused state based on the SoC of the plurality of battery cells in the paused state. As described above, the electronic device 100 may measure an SoC of each of the plurality of battery modules in the paused state based on an average of the SoC of the plurality of battery cells in the paused state included in each of the plurality of battery modules in the paused state.

In operation S525, the electronic device 100 according to an example embodiment may determine whether to perform first balancing of the plurality of battery modules. For example, when replacement of at least one or more battery modules among the plurality of battery modules has been performed after the first balancing of the battery modules has been previously performed, the electronic device 100 may determine to perform the first balancing of the battery modules. For example, when determining that all the SoC of the plurality of battery modules are uniform as a difference between the SoC of the plurality of battery modules is within a predetermined deviation, the electronic device 100 may determine not to perform the first balancing.

In operation S530, when determining to perform the first balancing of the battery modules in operation S525, the electronic device 100 according to an example embodiment may determine, among the plurality of battery modules, a balancing reference battery module and first battery modules that are objects of the first balancing. The reference battery module may correspond to a battery module having a minimum SoC among the plurality of battery modules in the battery rack. The first battery modules may correspond to battery modules having SoC higher than an SoC of the reference battery module within a first deviation. For example, when the SoC of the battery module having the minimum SoC among the plurality of battery modules is 80%, and when the first deviation is 10%, the electronic device 100 may determine battery modules, which have SoC greater than or equal to 80% and less than or equal to 88% among the plurality of battery modules in the battery rack, to be the first battery modules based on Equation 1.

In operation S540, the electronic device 100 according to an example embodiment may perform the first balancing of the battery modules at a first frequency until an SoC difference between the reference battery module and the first battery modules is within a predetermined deviation. For example, the predetermined deviation may correspond to a predefined second deviation having a value smaller than that of the first deviation which is predefined.

The predefined second deviation may be defined as a % value that is based on the SoC of the reference battery module. In other words, when the SoC of the reference battery module is a%, and when the predefined second deviation is c%, an SoC of a first battery module after performing of balancing, which is a reference for ending the first balancing, may be defined as such in the following Equation 2. [Equation 2] $a < SoC of first battery module after performing of balancing \leq a X \left(1+\frac{c}{100}\right) \left(%\right)$

For example, when the first deviation is 10% as described above, the electronic device 100 may determine the battery modules, which have the SoC greater than or equal to 80% and less than or equal to 88% among the plurality of battery modules in the battery rack, to be the first battery modules. When the second deviation which is a condition for ending the first balancing is 5%, the electronic device 100 may perform passive balancing of an entire plurality of battery cells included in the first battery module until an SoC difference between the reference battery module and the first battery module is within the second deviation. For example, under an assumption that a battery module having an SoC of 85% before performing of the first balancing is present among the first battery modules, since an SoC within the second deviation corresponds to an SoC greater than or equal to 80% and less than or equal to 84%, the electronic device 100 may perform the first balancing until the SoC of the battery module having the SoC of 85% before the performing of the first balancing becomes 84% and may end the first balancing when all the first battery modules satisfy the corresponding condition. In this case, the first frequency may be defined as the number of times of performing the first balancing over a lapse of time.

In operation S545, the electronic device 100 according to an example embodiment may determine whether to perform second balancing of battery cells in a battery module. For example, the electronic device 100 may determine whether to perform the second balancing for correcting a natural SoC deviation between the battery cells, which occurs due to a manufacturing property difference, deterioration, or an operating condition of a battery cell in the battery module.

In operation S550, when determining to perform the second balancing of the battery cells in the battery module in operation S545, the electronic device 100 according to an example embodiment may determine, among the battery cells of each of the plurality of battery modules, a reference battery cell and first battery cells that are objects of the second balancing. The reference battery cell may correspond to a battery cell having a minimum SoC among the plurality of battery cells in the battery module. The first battery cells may correspond to battery cells having SoC higher than an SoC of the reference battery cell within a third deviation. For example, when an SoC of a battery cell having a minimum SoC in a predetermined battery module is 90%, and when the third deviation is 5%, the electronic device 100 may determine battery cells, which have SoC greater than or equal to 90% and less than or equal to 94.5% among a plurality of battery cells in the battery module, to be the first battery cells.

In operation S560, the electronic device 100 according to an example embodiment may perform the second balancing of the battery cells at a second frequency until an SoC difference between the reference battery cell and the first battery cells is within a predetermined deviation. For example, the predetermined deviation may correspond to a predefined fourth deviation having a value smaller than that of the third deviation which is predefined. For example, when the third deviation is 5% as described above, the electronic device 100 may determine the battery cells, which have the SoC greater than or equal to 90% and less than or equal to 94.5% among the plurality of battery cells in the battery module, to be the first battery cells. When the fourth deviation which is a condition for ending the second balancing is 1%, the electronic device 100 may perform passive balancing of the first battery cells among the plurality of battery cells included in the battery module. For example, under an assumption that a battery module having an SoC of 92% before performing of the second balancing is present among the first battery cells, since an SoC within the second deviation corresponds to an SoC greater than or equal to 90% and less than or equal to 90.9%, the electronic device 100 may perform the second balancing until the SoC of the battery cell having the SoC of 92% before the performing of the second balancing becomes 90.9% and may end the second balancing when all the first battery cells satisfy the corresponding condition. In this case, the second frequency may be defined as the number of times of performing the second balancing over a lapse of time.

As described with reference to FIG. 5, the electronic device 100 may sequentially perform the first balancing which corresponds to balancing of the battery modules and the second balancing which corresponds to balancing of the battery cells in the battery module. In this case, the first deviation in the first balancing and the third deviation in the second balancing may differ from each other, and the second deviation in the first balancing and the fourth deviation in the second balancing may differ from each other. The electronic device 100 according to an example embodiment may perform the first balancing of the battery modules further frequently than the second balancing of the battery cells in the battery module in consideration of a replacement period for the battery module. That is, the electronic device 100 according to an example embodiment may perform the first balancing and the second balancing by allowing the first frequency for performing the first balancing to have a value larger than that of the second frequency for performing the second balancing.

The present specification and drawings have been described with respect to the example embodiments of the present disclosure. Although specific terms are used, it is only used in a general sense to easily explain the technical content of the present disclosure and to help the understanding of the invention, and is not intended to limit the scope of the specification. It will be apparent to those skilled in the art that other modifications based on the technical spirit of the present disclosure may be implemented in addition to the embodiments disclosed herein.

The present example embodiments may be represented by functional blocks and various processing steps. These functional blocks may be implemented by various numbers of hardware and/or software configurations that execute specific functions. For example, the present example embodiments may adopt integrated circuit configurations such as a memory, a processor, a logic circuit, and a look-up table that may execute various functions by control of one or more microprocessors or other control devices. Similarly to that elements may be executed by software programming or software elements, the present example embodiments may be implemented by programming or scripting languages such as C, C++, Java, and assembler language, including various algorithms implemented by combinations of data structures, processes, routines, or of other programming configurations. Functional aspects may be implemented by algorithms executed by one or more processors. In addition, the present example embodiments may adopt the related art for electronic environment setting, signal processing, and/or data processing, for example. The terms "mechanism", "element", "means", and "configuration" may be widely used and are not limited to mechanical and physical components. These terms may include the meaning of a series of routines of software in association with a processor.

The above-described embodiments are merely examples and other embodiments may be implemented within the scope of the following claims.

## Claims

1. An electronic device configured to perform a method of balancing battery cells, the electronic device comprising:
an information acquisition interface configured to acquire voltages of a plurality of battery cells in a plurality of battery modules included in a battery rack;
a memory configured to store an instruction; and
a processor connected to the memory,
wherein the processor is configured to:
measure the voltages of the plurality of battery cells in the plurality of battery modules included in the battery rack in a paused state;
measure states of charge (SoC) of the plurality of battery cells in the paused state based on the voltages and measure SoC of the plurality of battery modules in the paused state based on the SoC of the plurality of battery cells in the paused state,
determine first battery modules that are objects of first balancing among the plurality of battery modules; and
perform the first balancing of the first battery modules.

2. The electronic device of claim 1, wherein the processor is configured to determine battery modules, which have SoC higher than an SoC of a reference battery module that is a reference for the first balancing within a predefined first deviation, to be the first battery modules.

3. The electronic device of claim 1, wherein the processor is configured to:
determine a reference battery module that is a reference for the first balancing among the plurality of battery modules; and
perform the first balancing at a first frequency until a difference between the SoC of the first battery modules and an SoC of the reference battery module is within a predefined second deviation.

4. The electronic device of claim 1, wherein the processor is configured to:
determine reference battery cells that are a reference for second balancing among battery cells included in each of the plurality of battery modules;
determine battery cells, which have SoC higher than an SoC of a reference battery cell that is the reference for the second balancing within a predefined third deviation, to be first battery cells; and
perform the second balancing at a second frequency until a difference between the SoC of the first battery cells and SoC of the reference battery cells is within a predefined fourth deviation.

5. The electronic device of claim 3, wherein the first frequency has a value larger than that of the second frequency for performing second balancing of the plurality of battery cells which is included in each of the plurality of battery modules.

6. The electronic device of claim 2, wherein the first deviation in the first balancing is different from a third deviation in second balancing.

7. The electronic device of claim 1, wherein the processor is configured to measure the SoC of the plurality of battery modules in the paused state based on an average of the SoC of the plurality of battery cells in the paused state which is included in each of the plurality of battery modules in the paused state.

8. The electronic device of claim 4, wherein the processor is configured to determine reference battery cells, which have lowest SoC among the battery cells included in each of the plurality of battery module, to be the reference battery cell.

9. A non-transitory computer-readable recording medium in which a program for executing a method of any one of claims 1 through 8 on an electronic device is recorded.

10. A method of balancing battery cells, the method performed by an electronic device and comprising:
measuring voltages of a plurality of battery cells in a plurality of battery modules included in a battery rack in a paused state;
measuring states of charge (SoC) of the plurality of battery cells in the paused state based on the voltages and measuring SoC of the plurality of battery modules in the paused state based on the SoC of the plurality of battery cells in the paused state;
determining first battery modules that are objects of first balancing among the plurality of battery modules; and
performing the first balancing of the first battery modules.
